# EUROPÄISCHE PATENTANMELDUNG

(11) **EP 0 957 583 A2**
(43) Veröffentlichungstag der Anmeldung: **17.11.1999**
(21) Anmeldenummer: 99106044.3
(22) Anmeldetag: 25.03.1999
(51) Int. Cl.: H03K 17/693

(54) **Verzögerungsoptimierter Multiplexer**

(30) Priorität: 13.05.1998 DE 19821455
(71) Anmelder: SIEMENS AKTIENGESELLSCHAFT, 80333 München (DE)
(72) Erfinder: Graetz, Thoralf, 01307 Dresden (DE); Härle, Dieter, 81541 München (DE); Heyne, Patrick, 81541 München (DE); Johnson, Bret, 81737 München (DE)

(57) **Zusammenfassung**

Die Erfindung betrifft einen verzögerungsoptimierten Multiplexer aus wenigstens zwei Paßgliedern (1, 2), die jeweils über einen ersten Zweig durch ein Steuersignal (C2) direkt und über einen zweiten Zweig durch das durch einen Inverter (3) invertierte Steuersignal (C1) ansteuerbar sind. Zusätzlich ist im ersten Zweig ein weiteres Paßglied (8) vorgesehen, das die durch den Inverter (3) bedingte Verzögerung nachbildet, so daß die Paßglieder (1, 2) zeitgleich schaltbar sind.

## Beschreibung

Die vorliegende Erfindung betrifft einen verzögerungsoptimierten Multiplexer aus wenigstens zwei Paßgliedern, die jeweils über einen ersten Zweig durch ein Steuersignal direkt und über einen zweiten Zweig durch das durch einen Inverter invertierte Steuersignal ansteuerbar sind.

Multiplexer und auch Demultiplexer werden gewöhnlich mit Tristateinvertern oder Paßgliedern oder Nandgattern realisiert. Tristateinverter sind dabei Inverter, die drei Zustände, nämlich "1", "0" und "high resistance" (hoher Widerstand) haben.

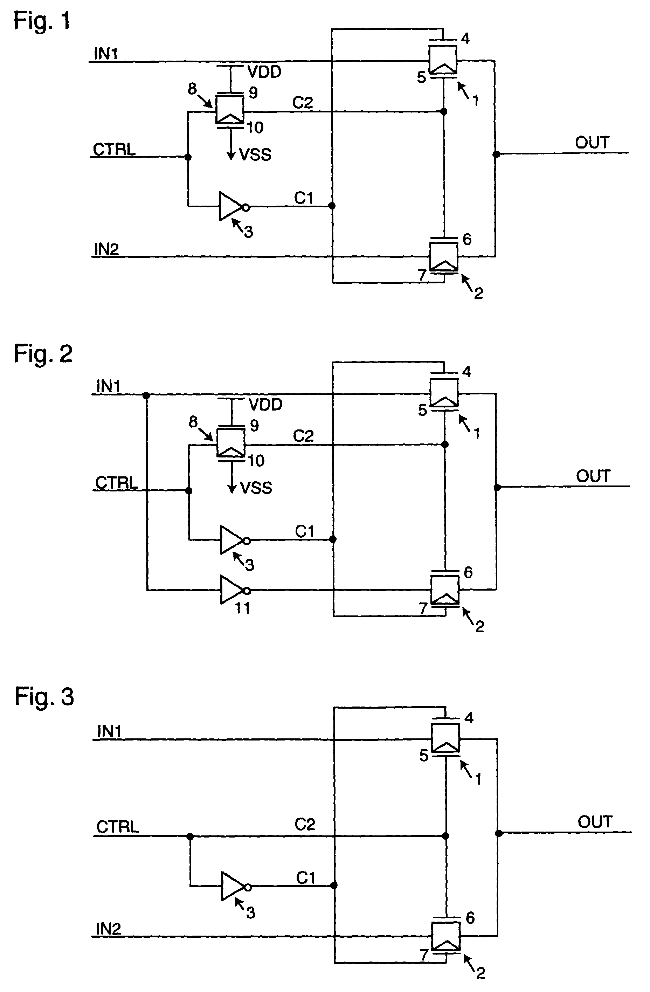

Fig. 3 zeigt ein Beispiel eines bestehenden Demultiplexers mit Paß- bzw. Transfergliedern 1, 2 und einem Inverter 3. Das Paßglied 1 besteht aus einem n-Kanal-MOS-Transistor 4 und einem p-Kanal-MOS-Transistor 5. Ebenso besteht das Paßglied 2 aus einem n-Kanal-MOS-Transistor 6 und einem p-Kanal-MOS-Transistor 7. Die Transistoren 4 und 5 liegen ebenso wie die Transistoren 6 und 7 jeweils parallel zueinander. Ein erstes Eingangssignal IN1 ist über die Source-Drain-Strecke der Transistoren 4, 5 geführt, während ein zweites Eingangssignal IN2 über die Source-Drain-Strecke der Transistoren 6, 7 geführt ist. Der Ausgang beider Paßglieder 1, 2 ist mit einem gemeinsamen Ausgangsknoten OUT verbunden. Die Gates der Transistoren 5, 6 sind durch ein Steuersignal C2 angesteuert, das einem Steuersignal CTRL entspricht. Weiterhin sind die Gates der Transistoren 4, 7 durch ein Steuersignal C1 angesteuert, das über den Inverter 3 aus dem Steuersignal CTRL gewonnen ist. Das heißt, die Steuersignale C1 und C2 sind zueinander invertiert.

Ist bei dem in Fig. 3 gezeigten Demultiplexer das Steuersignal C1 auf "0", so ist der Transistor 4 geschlossen, während der Transistor 7 offen ist. Das Steuersignal C2 ist in diesem Fall auf "1", was bedeutet, daß der Transistor 5 geschlossen ist, während der Transistor 6 offen ist. Mit anderen Worten, bei einem Steuersignal CTRL mit "1" leitet das Paßglied 2, während das Paßglied 1 sperrt.

Die Einfügung des Inverters 3 führt bei der Schaltungsanordnung von Fig. 3 nun dazu, daß das Signal C1 in bezug auf das Signal C2 etwas verzögert ist, da es den Inverter 3 durchlaufen muß. Mit anderen Worten, bei der Schaltungsanordnung von Fig. 1 werden die Paßglieder 1, 2 jeweils unterschiedlich schnell angesteuert, was bei zeitkritischen Anwendungen des Multiplexers bzw. Demultiplexers nachteilhaft ist, da die Eingangssignale IN1 und IN2 infolge der zeitlich unterschiedlichen Ansteuerung mit der gleichen Verzögerung zum Ausgang OUT geliefert werden.

Es ist daher Aufgabe der vorliegenden Erfindung, einen verzögerungsoptimierten Multiplexer bzw. Demultiplexer zu schaffen, der auch bei zeitkritischen Anwendungen ein zeitsynchrones Ausgangssignal zu liefern vermag.

Diese Aufgabe wird bei einem verzögerungsoptimierten Multiplexer der eingangs genannten Art erfindungsgemäß dadurch gelöst, daß im ersten Zweig ein zusätzliches Paßglied vorgesehen ist, das die durch den Inverter bedingte Verzögerung nachbildet.

Der erfindungsgemäße verzögerungsoptimierte Multiplexer (bzw. Demultiplexer) verwendet also ein zusätzliches optimiertes Paßglied in dem Zweig des Steuersignales, in welchem kein Inverter vorgesehen ist. Durch dieses zusätzliche Paßglied wird die durch den Inverter zwangsläufig eingeführte Zeitverzögerung nachgebildet, so daß die jeweiligen Steuersignale zeitgleich an den Paßgliedern ankommen.

Es hat sich auch gezeigt, daß sich Paßglieder generell als "Schalter" besser eignen als Tristateinverter, wenn diese über ein Prozeßfenster betrachtet werden. Tristateinverter sind aktive bzw. verstärkende Schalter, bei denen sich Prozeßschwankungen viel stärker auf die Schaltgeschwindigkeit auswirken als auf "passive" Paßglieder. So ist bei einem schwachen p-Kanal-FET die steigende Ausgangsflanke langsam, während bei einem n-Kanal-FET dies die fallende Ausgangsflanke ist. Das heißt, die Variation der aus einem Wafer gewonnenen Paßglieder ist geringer als prozeßbedingte Schwankungen bei der Herstellung von Tristateinvertern.

Auch bedingt die Trägheit der Paßglieder beim Schalten die Erzeugung eines gleichmäßig gegenüber dem Steuersignal verzögerten Ausgangssignales, selbst wenn die einzelnen Steuersignale für die jeweiligen Paßglieder nicht genau zum selben Zeitpunkt schalten.

Nachfolgend wird die Erfindung anhand der Zeichnungen näher erläutert. Es zeigen:
Fig. 1 und 2 jeweils Schaltbilder von zwei Ausführungsbeispielen des erfindungsgemäßen Multiplexers und
Fig. 3 ein Schaltbild eines bestehenden Multiplexers.

In den Fig. 1 und 2 werden füreinander entsprechende Bauteile die gleichen Bezugszeichen wie in der Fig. 3 verwendet.

Fig. 1 zeigt ein zusätzliches Paßglied 8 im Zweig des Steuersignales C2. Dieses zusätzliche Paßglied 8 besteht, wie die Paßglieder 1 und 2, aus einem n-Kanal-MOS-Transistor 9 und einem p-Kanal-MOS-Transistor 10. Gates dieser Transistoren 9 und 10, die wie die Transistoren 4 und 5 bzw. 6 und 7 parallel zueinander liegen, sind mit Versorgungsspannungen VDD bzw. VSS beaufschlagt.

Das Paßglied 8 ist so bemessen bzw. "optimiert", daß seine Verzögerung der Verzögerung des Inverters 3 entspricht. Dadurch wird erreicht, daß die Signale C1 und C2, die aus dem Steuersignal CTRL gewonnen sind, gleichzeitig die Transistoren 4 bis 7 schalten, so daß auch bei zeitkritischen Anwendungen eine Gewinnung des Ausgangssignales am Ausgang OUT mit jeweils derselben Verzögerung gewährleistet ist.

Fig. 2 zeigt ein Ausführungsbeispiel, bei welchem nur ein Eingangssignal IN1 anliegt, das direkt zu dem Paßglied 1 und über einen weiteren Inverter 11 zu dem Paßglied 2 geführt ist.

Eine vorteilhafte Anwendung des erfindungsgemäßen Multiplexers ist beispielsweise bei einem dynamischen Steuersignal CTRL und eher statischen Eingangssignalen IN1, IN2 gegeben, um beispielsweise ein ExOr-Glied mit konstanter Verzögerung des Steuersignales CTRL bis zum Ausgang OUT zu realisieren.

## Patentansprüche

1. Verzögerungsoptimierter Multiplexer aus wenigstens zwei Paßgliedern (1, 2), die jeweils über einen ersten Zweig durch ein Steuersignal (C2) direkt und über einen zweiten Zweig durch das durch einen Inverter (3) invertierte Steuersignal (C1) ansteuerbar sind,
**dadurch gekennzeichnet,**
daß im ersten Zweig ein zusätzliches Paßglied (8) vorgesehen ist, das die durch den Inverter (3) bedingte Verzögerung nachbildet.

2. Verzögerungsoptimierter Multiplexer nach Anspruch 1,
**dadurch gekennzeichnet,**
daß an jedem der wenigstens zwei Paßglieder (1, 2) ein getrenntes Eingangssignal (IN1, IN2) anliegt.

3. Verzögerungsoptimierter Multiplexer nach Anspruch 1,
**dadurch gekennzeichnet,**
daß das eine der wenigstens zwei Paßglieder (1, 2) mit einem Eingangssignal und das andere der wenigstens zwei Paßglieder (2, 1) mit dem invertierten Eingangssignal beautschlagt ist.

4. Verzögerungsoptimierter Multiplexer nach einem der Ansprüche 1 bis 3,
**dadurch gekennzeichnet,**
daß die Paßglieder (1, 2, 8) aus einem n-Kanal-MOS-Transistor (4, 6, 9) und einem p-Kanal-MOS-Transistor (5, 7, 10) bestehen, die parallel zueinander geschaltet sind.
